# EUROPEAN PATENT APPLICATION

(11) **EP 4 579 188 A1**
(43) Date of publication of application: **02.07.2025**
(21) Application number: 23856936.2
(22) Date of filing: 09.06.2023
(51) Int. Cl.: G01C 19/5684, H10N 30/063, H10N 30/30, H10N 30/853, H10N 30/87

(54) **VIBRATION-TYPE ANGULAR VELOCITY DETECTOR**

(30) Priority: 25.08.2022 JP 2022134368
(71) Applicant: Sumitomo Precision Products Co., Ltd., Hyogo 660-0891 (JP)
(72) Inventor: KIUCHI, Mario, Amagasaki-shi, Hyogo 660-0891 (JP)
(74) Representative: Viering, Jentschura & Partner mbB Patent- und Rechtsanwälte
(86) International application number: PCT/JP2023/021578
(87) International publication number: WO 2024/042819

(57) **Abstract**

A vibration-type angular velocity sensor 100 according to this invention includes a vibrator 10 including a substrate 1 including a first silicon layer 11 including a crystal plane with Miller indices (111) and a second silicon layer 13 including a crystal plane with Miller indices (100), and a vibration exciter 2 including a piezoelectric layer 21 arranged on a side of the second silicon layer 13 of the substrate 1 opposite to the first silicon layer 11 side. The piezoelectric layer 2 includes a piezoelectric element material that includes at least a crystal plane with Miller indices (100) or Miller indices (001) and is grown on the side of the second silicon layer 13 opposite to the first silicon layer 11.

## Description

### Technical Field

The invention relates to a vibration-type angular velocity sensor, and in particular to a vibration-type angular velocity sensor including a substrate including a silicon layer.

Vibration-type angular velocity sensors including substrates including silicon layers are known in the art. Such a vibration-type angular velocity sensor is disclosed, for example, in Japanese Patent Laid-Open Publication No. JP 2003-302222.

The above Japanese Patent Laid-Open Publication No. JP 2003-302222 discloses a thin-film micromechanical vibrator gyro (vibration-type angular velocity sensor) including a silicon wafer including a silicon layer. The thin-film micromechanical vibrator gyro includes a piezoelectric thin film. The piezoelectric thin film is deposited on a surface of the silicon layer of the silicon wafer. The piezoelectric thin film is configured to vibrate on the surface of the silicon layer of the silicon wafer based on an electric field generated by a voltage applied. The thin-film micromechanical vibrator gyro detects angular velocity through the vibration. Such a piezoelectric thin film is a film of lead zirconate titanate.

### Prior Art

### Patent Document

Patent Document 1: Japanese Patent Laid-Open Publication No. JP 2003-302222

### Summary of the Invention

### Problems to be Solved by the Invention

Here, in the known thin-film micromechanical vibrator gyros, such as the thin-film micromechanical vibrator gyro described in the above Japanese Patent Laid-Open Publication No. JP 2003-302222, polycrystalline piezoelectric thin films, which are typical piezoelectric thin films, are used in some cases. Since a magnitude (drive amount) of vibration of the polycrystalline piezoelectric thin film is relatively small if the applied voltage is low, it is necessary to increase the applied voltage to surely provide a sufficient drive amount. In this case, the increased applied voltage reduces tolerance of the piezoelectric thin film to the voltage (tolerance of its electrical insulation), and as a result hastens deterioration of the piezoelectric thin film. To address this, in the known thin-film micromechanical vibrator gyros, such as the thin-film micromechanical vibrator gyro described in the above Japanese Patent Laid-Open Publication No. JP 2003-302222, it can be conceived to deposit, instead of the polycrystalline piezoelectric thin film, a piezoelectric thin film including at least a crystal plane with Miller indices (100) or Miller indices (001) capable of surely providing a sufficient drive amount even if the applied voltage is low.

Here, although not stated in the above Japanese Patent Laid-Open Publication No. JP 2003-302222, it can be conceived that a silicon wafer including a silicon layer that includes a crystal plane with Miller indices (111) is selected from silicon layers including a various sets of Miller indices in some cases in the known thin-film micromechanical vibrator gyros, such as the thin-film micromechanical vibrator gyro described in the above Japanese Patent Laid-Open Publication No. JP 2003-302222. In such a case, when a piezoelectric thin film that includes at least a crystal plane with Miller indices (100) or Miller indices (001) is deposited on a surface of the silicon layer which has a diamond structure and that includes the crystal plane with Miller indices (111), defects, such as distortion and improper junction between crystal structures (misfit dislocation), are likely to occur due to shape difference between the crystal planes. For this reason, in the known thin-film micromechanical vibrator gyros, such as the thin-film micromechanical vibrator gyro described in the above Japanese Patent Laid-Open Publication No. JP 2003-302222, it is difficult to deposit the piezoelectric thin film (piezoelectric layer) that includes at least the crystal plane with Miller indices (100) or Miller indices (001) on the surface of the silicon layer that includes the crystal plane with Miller indices (111) in the silicon wafer (substrate).

The present invention is intended to solve the above problems, and one object of the present invention is to provide a vibration-type angular velocity sensor capable of depositing a piezoelectric layer that includes at least the crystal plane with Miller indices (100) or Miller indices (001) on or above a substrate including a silicon layer that includes a crystal plane with Miller indices (111).

### Means for Solving the Problems

In order to attain the aforementioned object, a vibration-type angular velocity sensor according to one aspect of the present invention includes a vibrator including a substrate including a first silicon layer including a crystal plane with Miller indices (111) and a second silicon layer arranged on one side in a thickness direction of the first silicon layer and including a crystal plane with Miller indices (100), and a vibration exciter including a piezoelectric layer arranged on a side of the second silicon layer of the substrate opposite to the first silicon layer side, wherein the piezoelectric layer includes a piezoelectric element material that includes at least a crystal plane with Miller indices (100) or Miller indices (001) and is grown on the side of the second silicon layer opposite to the first silicon layer side.

In the vibration-type angular velocity sensor according to the one aspect of the present invention, as discussed above, the piezoelectric layer includes the piezoelectric element material that includes at least a crystal plane with Miller indices (100) or Miller indices (001) and is grown on the side of the second silicon layer opposite to the first silicon layer side. Here, the substrate includes not only the first silicon layer which has a diamond structure and that includes the crystal plane with Miller indices (111) and has isotropic Young's moduli but also the second silicon layer that includes the crystal plane with Miller indices (100). According to this configuration in which the piezoelectric layer is deposited on or above the second silicon layer of the substrate, since a shape of the crystal plane of the piezoelectric layer and a shape of the crystal plane of the second silicon layer are substantially the same as each other, it is possible to prevent occurrence of distortion, improper junction between crystal structures (misfit dislocation), and the like due to shape difference between the crystal planes in a crystal structure of a junction part between the vibration exciter including the piezoelectric layer and the second silicon layer of the substrate. Consequently, the piezoelectric layer that includes at least the crystal plane with Miller indices (100) or Miller indices (001) can be deposited on or above the substrate including the first silicon layer including the crystal plane with Miller indices (111). Also, according to this configuration in which the piezoelectric layer is provided on or above the substrate including the first silicon layer including the crystal plane with Miller indices (111), since the first silicon layer which has a diamond structure and that includes the crystal plane with Miller indices (111) has isotropic Young's moduli, the piezoelectric layer can properly vibrate when the piezoelectric layer vibrates on or above the substrate. Consequently, since the piezoelectric layer can properly vibrate, the vibration-type angular velocity sensor can accurately detect angular velocity.

In the vibration-type angular velocity sensor according to the aforementioned one aspect, it is preferable that the vibrator has a rotational symmetric shape with respect to a center of the vibrator as viewed from the one side in the thickness direction, and vibrates rotational-symmetrically with respect to the center of the vibrator. Here, Young's moduli of the first silicon layer, which has a predominant influence on the vibrator's mechanical properties, is required to be isotropic in plane directions of the substrate in order for the vibrator having the rotational symmetric shape to rotational-symmetrically vibrate. Accordingly, in the vibration-type angular velocity sensor, since the vibrator having the rotational symmetric shape and rotational-symmetrically vibrating is provided on or above the substrate including the first silicon layer which has a diamond structure and that includes the crystal plane with Miller indices (111) and has isotropic Young's moduli, it is possible to realize a vibration-type detector effectively using a property of isotropic Young's moduli of the first silicon layer which has a diamond structure and that includes the crystal plane with Miller indices (111).

In the vibration-type angular velocity sensor according to the aforementioned one aspect, it is preferable that a thickness of the second silicon layer is smaller than a thickness of the first silicon layer in the thickness direction. According to this configuration in which the thickness of the second silicon layer is smaller than the thickness of the first silicon layer, since isotropic deformation of the first silicon layer has a greater effect than anisotropic deformation of the second silicon layer in vibration of the piezoelectric layer, the substrate can be isotropically deformed. Consequently, the vibrator can rotational-symmetrically vibrate.

In the vibration-type angular velocity sensor according to the aforementioned one aspect, it is preferable that the piezoelectric layer includes lead zirconate titanate as the piezoelectric element material, which includes at least the crystal plane with Miller indices (100) or Miller indices (001). According to this configuration, since a sufficient drive amount can be provided to the vibrator by the lead zirconate titanate, which has better piezoelectric performance than other materials, it is possible to further prevent deterioration of the vibrator from accelerating.

In the aforementioned vibration-type angular velocity sensor in which the vibrator has rotational symmetric shape, it is preferable that the vibrator has a ring shape as viewed from the one side. According to this configuration, since an area of the ring-shaped vibrator to be vibrated can be smaller than that of a disc-shaped vibrator having the same diameter as the ring-shaped vibrator, power supplied to the vibrator to be vibrated can be relatively small.

In the vibration-type angular velocity sensor according to the aforementioned one aspect, it is preferable that the vibration exciter further includes a first electrode arranged between the piezoelectric layer and the second silicon layer to apply a voltage to the piezoelectric layer, and a second electrode arranged on the one side of the piezoelectric layer to apply the voltage to the piezoelectric layer; and that the first electrode is formed of an electrode material that includes a crystal plane with Miller indices (100), and is grown on a surface of the second silicon layer on the one side. According to this configuration, since the piezoelectric layer that includes at least the crystal plane with Miller indices (100) or Miller indices (001) can be provided on the one side of the first electrode by forming the first electrode of an electrode material including a crystal plane with Miller indices (100), it is possible to provide a vibration-type angular velocity sensor including a vibrator capable of surely providing a sufficient drive amount even if the voltage applied through the first electrode and the second electrode is low. Also, since the first electrode including the crystal plane with Miller indices (100) is deposited on one side of the second silicon layer including the crystal plane with Miller indices (100) so that a shape of the crystal plane of the first electrode and a shape of the crystal plane of the second silicon layer are the same as each other, it is possible to prevent occurrence of distortion, improper junction between crystal structures (misfit dislocation), and the like due to shape difference between the crystal planes in a crystal structure of a junction part between the first electrode and the second silicon layer.

In this configuration, it is preferable that a lattice misfit between the first electrode and the piezoelectric layer, and a lattice misfit between the first electrode and the second silicon layer are not greater than 10%. According to this configuration, it is possible to further prevent occurrence of distortion, improper junction between crystal structures (misfit dislocation), and the like due to lattice constant difference in a junction part between the piezoelectric layer and the first electrode, and a junction part between the second silicon layer and the first electrode. Here, the lattice misfit refers to a lattice mismatch ratio based on a lattice constant of a layer on one side and a lattice constant of a layer on another side. Also, the lattice mismatch includes both a case in which the lattice constant of the layer on the one side and the lattice constant of the layer on the another side have a difference (in a case of a lattice mismatch ratio of nonzero percent), and a case in which the lattice constant of the layer on the one side and the lattice constant of the layer on the another side have no difference (in a case of a lattice mismatch ratio of zero percent).

In the aforementioned vibration-type angular velocity sensor in which a lattice misfit between the first electrode and the piezoelectric layer, and a lattice misfit between the first electrode and the second silicon layer are not greater than 10%, it is preferable that a lattice constant of a crystal structure of the first electrode is substantially equal to a lattice constant of a crystal structure of the piezoelectric layer and a lattice constant of a crystal structure of the second silicon layer of the substrate. According to this configuration, it is possible to furthermore prevent occurrence of distortion, improper junction between crystal structures (misfit dislocation), and the like due to crystal structure lattice constant difference of a crystal structure in the junction part between the piezoelectric layer and the first electrode, and a crystal structure in the junction part between the second silicon layer and the first electrode. Consequently, the vibration exciter that includes the crystal plane with Miller indices (100) can be deposited on or above the substrate including the crystal plane with Miller indices (111). Here, the lattice constant of the crystal structure of the first electrode is substantially equal refers to that the lattice constant of the crystal structure of the first electrode is the same as, slightly greater, or slightly smaller than the lattice constant of the crystal structure of the piezoelectric layer and the lattice constant of the crystal structure of the second silicon layer.

In the vibration-type angular velocity sensor according to the aforementioned one aspect, it is preferable that the substrate further includes a silicon dioxide layer that is formed of non-crystalline silicon dioxide and is bonded on a surface of the first silicon layer on the one side and bonded on a surface of the second silicon layer opposite to the one side in the thickness direction. According to this configuration, as compared with a case in which the first silicon layer and the second silicon layer are directly bonded to each other, the second silicon layer can be easily bonded on the silicon dioxide layer above the first silicon layer by hydrogen-bonding the first silicon layer and the second silicon layer to the silicon dioxide layer and then applying high temperature treatment to them.

In this configuration, it is preferable that the substrate is an SOI (Silicon on Insulator) substrate that includes the first silicon layer as a handle layer, which is supported when the substrate is moved, the silicon dioxide layer, and the second silicon layer as a device layer. According to this configuration, it is possible to easily produce vibration-type angular velocity sensors by using the SOI substrate.

### Effect of the Invention

According to the present invention, the piezoelectric layer that includes at least the crystal plane with Miller indices (100) or Miller indices (001) can be deposited on or above the substrate including the silicon layer that includes the crystal plane with Miller indices (111) as discussed above.

### Brief Description of the Drawings

FIG. 1 is a plan view showing a ring gyroscope according to one embodiment.
FIG. 2 is a plan view showing the ring gyroscope according to the one embodiment with its vibrator being vibrating.
FIG. 3 is a plan view showing the ring gyroscope according to the one embodiment with its vibrator being detecting angular velocity.
FIG. 4 is a cross-sectional view of the gyroscope taken along a line IV-IV in FIG. 1.

### Modes for Carrying Out the Invention

Embodiments according to the present invention will be described with reference to the drawings.

### (Configuration of Ring Gyroscope)

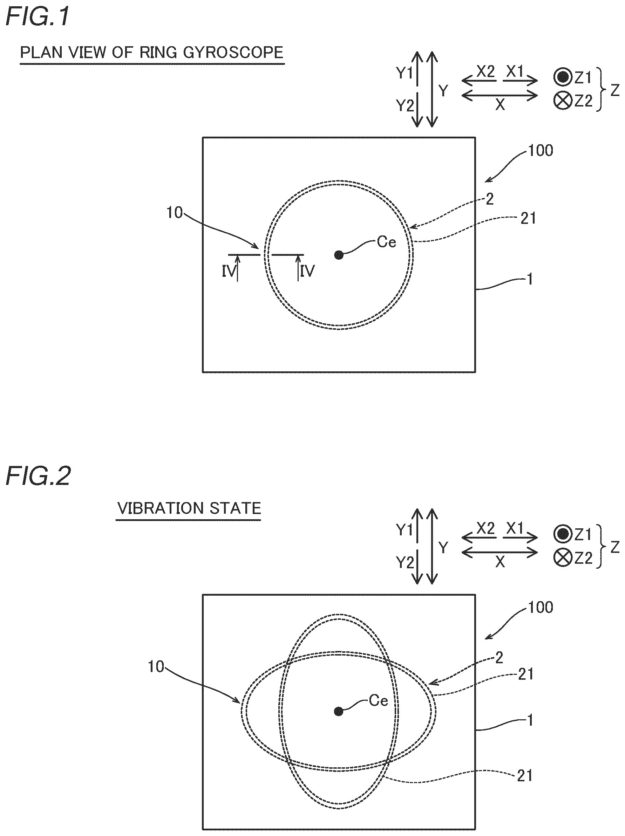

The following description describes a configuration of a ring gyroscope 100 according to one embodiment of the present invention with reference to FIGS. 1 to 4. Here, the ring gyroscope 100 is also a ring-type resonator. Also, here, ring gyroscope 100 is an example of a "vibration-type angular velocity sensor" in the claims.

As shown in FIG. 1, the ring gyroscope 100 is a sensor for detecting angular velocity in digital cameras, smartphones, portable game machines, robots, car navigation systems, vehicles, and the like. The ring gyroscope 100 is, for example, a MEMS (Micro Electro Mechanical Systems) device.

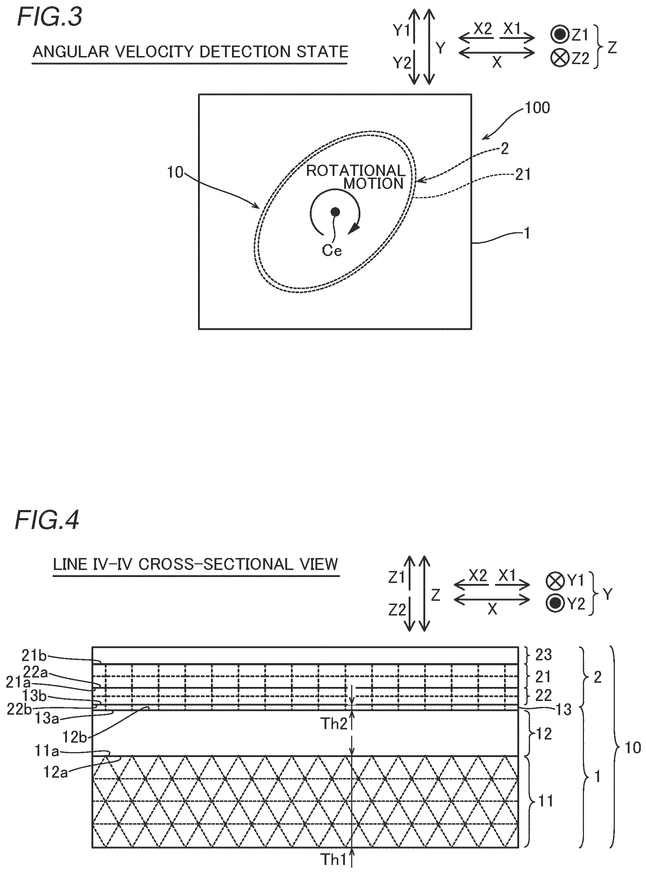

The ring gyroscope 100 includes a vibrator 10 including a substrate 1 and a vibration exciter 2. The ring gyroscope 100 is configured to excite vibration in a predetermined direction of the vibration exciter 2 on a surface 13b of the substrate 1. Here, in the ring gyroscope 100, the vibration of the vibrator 10 is shifted by Coriolis force generated by applying a rotational motion to the vibrator 10 vibrating in the predetermined direction. The ring gyroscope 100 is configured to detect angular velocity based on the shift of the vibration of the vibrator 10. Here, a direction in which the substrate 1 and the vibration exciter 2 are aligned is defined as Z directions, and directions toward a vibration exciter 2 side and a substrate 1 side in the Z directions are defined as Z1 and Z2 directions, respectively. The Z directions are parallel to a thickness direction of the substrate 1. One of directions perpendicular to the Z direction is defined as one of X directions, and another direction perpendicular to the X direction is defined as one of Y directions. Also, one of the X directions is defined as an X1 direction, and another direction of the X directions is defined as an X2 direction. Also, one of the Y directions is defined as an Y1 direction, and another direction of the Y directions is defined as an Y2 direction. The X/Y direction, which is collectively called the X and Y directions, is a direction parallel to a direction (in-plane direction) of the surface 13b of the substrate 1 (see FIG. 4).

Specifically, as shown in FIG. 2, the vibrator 10 has a rotational symmetric shape with respect to a center Ce of the vibrator 10 as viewed from a Z1-direction side. In other words, the vibrator 10 has a ring shape as viewed from the Z1-direction side. Also, the ring-shaped vibrator 10 is configured to vibrate rotational-symmetrically with respect to the center Ce of the vibrator 10. Specifically, the vibrator 10 repeatedly and alternately generates vibration in the Y direction and vibration in the X direction, which is perpendicular to the Y direction. As shown in FIG. 3, the vibrator 10 is brought into vibration in a direction inclined with respect to the Y direction as the predetermined direction, or the like, by the Coriolis force, which is generated when rotational motion (e.g., rotational motion due to vehicle turning) is applied to the vibrator. Accordingly, the ring gyroscope 100 can detect angular velocity.

Here, other vibrators, which do not have a rotational symmetric shape such as the ring shape and are not brought in rotational symmetric vibration, are not required to keep the rotational symmetric shape when the other vibrators vibrate, and as a result the other vibrators are not required to vibrate with loads being uniformly applied to the entire other vibrators. Contrary to this, as discussed above, since the vibrator 10 according to this embodiment has the rotational symmetric shape such as the ring shape and is required to be brought in rotational symmetric vibration, the vibrator is required to keep the rotational symmetric shape when the vibrator 10 vibrates. For this reason, when the vibrator 10 vibrates in the in-plane direction of the surface 13b of the substrate 1, even if the same load is applied in a rotational symmetric direction to bring the vibrator, which has the rotational symmetric shape, in vibration in the rotational symmetric shape, in a case in which Young's moduli in directions each of which is the in-plane direction of the substrate 1 are different from each other, deformations in the directions each of which is the in-plane direction of the substrate 1 become different from each other, and as a result the rotational symmetric shape of the vibrator 10 cannot be kept. To address this, in the vibrator 10 according to this embodiment, the Young's moduli of the material of the vibrator 10 is necessarily isotropic.

To achieve this, the ring gyroscope 100 has a structure that properly vibrates the vibrator 10 and reduces the voltage required for the proper vibration to a relatively low voltage. Specifically, the vibrator 10 includes the substrate 1, and the vibration exciter 2 including a piezoelectric layer 21, a first electrode 22 and a second electrode 23, as shown in FIG. 4.

### (Substrate)

The Substrate 1 is a ring-shaped SOI (Silicon on Insulator) substrate. The substrate 1 includes a first silicon layer 11, a silicon dioxide layer 12, and a second silicon layer 13.

### <First Silicon Layer>

The first silicon layer 11 is a handle layer, which is supported when the substrate 1 is moved, in the SOI substrate. The first silicon layer 11 is a part that is the closest to a Z2-direction side in the substrate 1. The first silicon layer 11 is formed of a single-crystal silicon (Si). Here, a crystal structure of silicon in the first silicon layer 11 is the so-called diamond structure. The first silicon layer 11 includes a crystal plane with Miller indices (111). The first silicon layer 11 includes a crystal structure of silicon that includes a crystal plane with Miller indices (111). The first silicon layer 11 has a surface 11a that includes a crystal plane (equilateral-triangular plane) with Miller indices (111) on the Z1-direction side. Here, the Young's moduli of the first silicon layer 11, which has a diamond structure, on the crystal plane with the Miller indices (111) is isotropic. A lattice constant of the crystal structure of the silicon in the first silicon layer 11 is approximately 0.5431 nm. Here, the single crystal is a concept including not only a crystal in a completely single crystal state but also a crystal in a nearly single crystal state.

The Miller indices refer to indices for notation of a crystal plane that is defined by atoms in a unit lattice in a crystal structure based on three crystal axes of the crystal structure. Also, the crystal refers to a solid in which atoms, molecules, ions and the like that form a substance are arranged in a spatially ordered arrangement. The crystal structure refers to an arrangement structure of the atoms, the molecules and the ions, which form the substance. The lattice refers to a periodic arrangement of the crystal structure. The unit lattice is a repeated lattice that has the smallest unit in the periodic arrangement of the crystal structure. In the crystal, a number of crystal planes are aligned at a constant interval away from each other. The number of crystal planes are parallel to each other. A direction in which the number of crystal planes are aligned is a crystal orientation (a direction perpendicular to the crystal plane). The lattice constant is a length of one side of the unit lattice.

### <Silicon Dioxide Layer>

The silicon dioxide layer 12 is provided to bond the first silicon layer 11 and the second silicon layer 13 to each other. That is, the silicon dioxide layer 12 is formed of non-crystalline silicon dioxide (SiO₂) bonded to the surface 11a of the first silicon layer 11 on the Z1-direction side (one side) and to a surface 13a of the second silicon layer 13 on the Z2-direction side (another side). Here, non-crystalline means that something is a homogeneous solid substance whose mechanical properties, such as Young's moduli, do not vary with direction.

Specifically, the silicon dioxide layer 12 is bonded to the surface 11a of the first silicon layer 11 on the Z1-direction side by hydrogen-bonding the surface 12a of the silicon dioxide layer 12 on the Z2-direction side to the surface 11a of the first silicon layer 11 on the Z1-direction side and then applying high temperature treatment to them. Also, the silicon dioxide layer 12 is bonded to the surface 13a of the second silicon layer 13 on the Z2-direction side by hydrogen-bonding the surface 12b of the silicon dioxide layer 12 on the Z1-direction side to the surface 13a of the second silicon layer 13 on the Z2-direction side, and then applying high temperature treatment to them.

The silicon dioxide layer 12 is arranged between the first silicon layer 11 and the second silicon layer 13 in the Z direction.

Since the silicon dioxide layer 12 is non-crystalline (amorphous), its Young's moduli is isotropic.

### <Second Silicon Layer>

The second silicon layer 13 is a device layer of the SOI substrate. The second silicon layer 13 is a part that is the closest to the Z1-direction side in the substrate 1. The second silicon layer 13 is arranged on the Z1-direction side with respect to the first silicon layer 11. Specifically, the second silicon layer 13 is arranged on the silicon dioxide layer 12 on the Z1-direction side above the first silicon layer 11.

The second silicon layer 13 is formed of single-crystal silicon. The second silicon layer 13 includes a crystal plane with Miller indices (100). The second silicon layer 13 is formed of a crystalline structure of silicon including the crystal plane with Miller indices (100). The second silicon layer 13 has the surface 13b that includes a crystal plane (rectangular plane) with Miller indices (100) on the Z1-direction side. The second silicon layer 13 has the surface 13a that includes a crystal plane (rectangular plane) with Miller indices (100) on the Z2-direction side. Here, the second silicon layer 13, which includes the crystal plane with Miller indices (100), has anisotropic Young's moduli. A lattice constant of the crystal structure of the silicon in the second silicon layer 13 is approximately 0.5431 nm.

The second silicon layer 13 is a layer for transition from the crystal plane of the first silicon layer 11 with Miller indices (111) to the crystal plane with Miller indices (100) in the substrate 1.

### (Thicknesses of First and Second Silicon Layers)

A thickness Th2 of the second silicon layer 13 is smaller than a thickness Th1 of the first silicon layer 11 in the Z direction. The thickness Th1 of the first silicon layer 11 is preferably not smaller than 5.0 [µm] and not greater than 500 [µm]. The second silicon layer 13 is a very thin layer thinner than the first silicon layer 11. It is preferable that the thickness Th2 of the second silicon layer 13 is approximately 1% of the thickness Th1 of the first silicon layer 11. In other words, the thickness Th2 of the second silicon layer 13 is preferably not smaller than 0.05 [µm] and not greater than 5.0 [µm].

According to this case in which the thickness Th2 of the second silicon layer 13 is smaller than the thickness Th1 of the first silicon layer 11, since isotropic deformation of the first silicon layer 11 has a greater effect than anisotropic deformation of the second silicon layer 13 in vibration of the vibrator 10, the substrate 1 can be isotropically deformed. Consequently, the piezoelectric layer 21 can properly vibrate on the surface 13b of the substrate 1 on the Z1-direction side.

### (Vibration Exciter)

The vibration exciter 2 is a part that generates (excites) vibration in the ring gyroscope 100. That is, the piezoelectric layer 21 in the vibration exciter 2 is resonated at a high frequency corresponding to a predetermined wavelength by an electric field generated by the voltage generated by the first electrode 22 and the second electrode 23. The vibration exciter 2 is arranged on a side (Z1-direction side) of the second silicon layer 13 opposite to the first silicon layer 11 side in the substrate 1. The first electrode 22 in the vibration exciter 2 is formed to include a crystal structure including a crystal plane with Miller indices (100) to match the crystal plane of the second silicon layer 13 with Miller indices (100). Also, in the vibration exciter 2, the piezoelectric layer 21 is formed to include at least a crystal plane with Miller indices (100) or Miller indices (001) to match the crystal plane of the second silicon layer 13 with Miller indices (100). In other words, the piezoelectric layer 21 includes a crystal plane with Miller indices (100) as a preferred orientation. Here, the preferred orientation refers to a crystal including a crystal plane with specific Miller indices (e.g., (100)) that grows preferentially over a crystal plane with other Miller indices (e.g., (001)).

Specifically, the piezoelectric layer 21 is formed of a single-crystal piezoelectric element material that includes a crystal plane with Miller indices (100) as the preferred orientation and is grown on the side (Z1-direction side) of the second silicon layer 13 opposite to the first silicon layer 11 by using epitaxial growth. That is, the piezoelectric layer 21 is bonded to a surface 22a on the Z1-direction side of the crystal plane of the first electrode 22 with Miller indices (100) by growing lead zirconate titanate (PZT) as the single-crystal piezoelectric element material including the crystal plane with Miller indices (100) as the preferred orientation by using epitaxial growth. The piezoelectric layer 21 is arranged on the first electrode 22 on the Z1-direction side above the second silicon layer 13.

Since the piezoelectric layer 21 is a thin film of a single crystal of a material different from the first electrode 22, the piezoelectric layer is formed on the surface 22a of the first electrode 22 on the Z1-direction side by using heteroepitaxial growth among epitaxial growth methods. A heteroepitaxial growth method to be suitably used can be provided by a vapor-phase epitaxial growth method in which a component in a gas phase is deposited on the surface 22a of the first electrode 22 on the Z1-direction side, a liquid-phase epitaxial growth method in which a crystalline component in a supersaturated solution is deposited on the surface 22a of the first electrode 22 on the Z1-direction side, a solid-phase epitaxial growth method in which a material to be deposited on the surface 22a of the first electrode 22 on the Z1-direction side is heated by irradiation of the material with an electron beam or the like, and a molecular-beam epitaxial growth method in which crystals are composed on the surface 22a of the first electrode 22 on the Z1-direction side in ultrahigh vacuum.

Here, the surface 21a on the Z2-direction side of the piezoelectric layer 21 formed by using epitaxial growth is formed of a crystal plane (rectangular plane) with Miller indices (100) as the preferred orientation. Also, the surface 21b on the Z1-direction side of the piezoelectric layer 21 formed by using epitaxial growth is formed of a crystal plane (rectangular plane) with Miller indices (100) as the preferred orientation.

Since the piezoelectric layer 21 including the crystal plane with Miller indices (100) as the preferred orientation is formed on the surface 22a on the Z1-direction side of the first electrode 22 including the crystal plane with Miller indices (100) as discussed above, a shape of the crystal plane of the surface 22a of the first electrode 22 on the Z1-direction side is substantially the same as a shape of the crystal plane of the surface 21a of the piezoelectric layer 21 on the Z2-direction side. Also, a lattice misfit between the first electrode 22 and the piezoelectric layer 21 is not greater than 10%. Here, a lattice constant of the crystal structure of the piezoelectric layer 21 is substantially equal to a lattice constant of the crystal structure of the first electrode 22. In other words, the lattice constant of the crystal structure of the piezoelectric layer 21 is equal to, slightly greater, or slightly smaller than the lattice constant of the crystal structure of the first electrode 22.

For these reasons, distortion, improper junction between crystal structures (misfit dislocation), and the like due to difference between the shapes of the crystal planes and difference between lattice constants are unlikely to occur in the crystal structure in a junction part between the piezoelectric layer 21 and the first electrode 22. From this viewpoint, the aforementioned lead zirconate titanate is used in the piezoelectric layer 21, since it suppresses occurrence of distortion and misfit dislocation in the crystal structure in the junction part between the piezoelectric layer 21 and the first electrode 22, and has a high temperature resistance, and the like.

The piezoelectric layer 21 has the ring shape (see FIG. 1) as viewed from the Z1-direction side. The ring-shaped piezoelectric layer 21 is bonded on the first electrode 22 above the substrate 1.

### (First Electrode)

The first electrode 22 is arranged between the piezoelectric layer 21 and the second silicon layer 13 to apply a voltage to the piezoelectric layer 21. In other words, the first electrode 22 is arranged on the Z2-direction side of the piezoelectric layer 21, and is arranged on the Z1-direction side of the second silicon layer 13. The first electrode 22 is a multilayer electrode that includes an electrically insulating layer, an electrode layer, and a buffer layer. The first electrode 22 is formed of single-crystal electrode materials with Miller indices (100), and is grown on the surface 12b of the second silicon layer 13 on the Z1-direction side by using epitaxial growth (heteroepitaxial growth). Here, the first electrode 22 may be a single-layer electrode. Also, the aforementioned vapor-phase epitaxial growth method, liquid-phase epitaxial growth method, solid-phase epitaxial growth method, molecular beam epitaxial growth method, or the like can be suitably used for the heteroepitaxial growth.

In other words, the electrode material of the electrically insulating layer may include zirconium oxide (ZrO₂), yttria stabilized zirconia (YSZ) or the like that includes a crystal plane (rectangular plane) with Miller indices (100). The electrode material of the electrode layer may include platinum (Pt), iridium (Ir), cerium oxide (CeO₂), high-temperature copper oxide superconductor (LSCO), lanthanum (La), strontium (Sr) or the like that includes a crystal plane (rectangular plane) with Miller indices (100). The electrode material of the buffer layer may include strontium ruthenate (SrRuO₃), lanthanum nickelate (LaNiO₃) or the like that includes a crystal plane (rectangular plane) with Miller indices (100). Note that the electrode material of the first electrode 22 is not limited to the aforementioned electrode materials.

Since the first electrode 22 including the crystal plane with Miller indices (100) is formed on the surface 13b on the Z1-direction side of the second silicon layer 13 including the crystal plane with Miller indices (100) as discussed above, a shape of the crystal plane of the surface 13b of the second silicon layer 13 on the Z1-direction side is the same as a shape of the crystal plane of the surface 22b of the first electrode 22 on the Z2-direction side.

Also, a lattice misfit between the first electrode 22 and the second silicon layer 13 is not greater than 10% similar to the lattice misfit between the first electrode 22 and the piezoelectric layer 21. Here, the lattice constant of the crystal structure of the first electrode 22 is substantially equal to the lattice constant of the crystal structure of the piezoelectric layer 21 and the lattice constant of the crystal structure of the second silicon layer 13. That is, the lattice constant of the crystal structure of the first electrode 22 is the same as, slightly greater, or slightly smaller than the lattice constant of the crystal structure of the piezoelectric layer 21 and the lattice constant of the crystal structure of the second silicon layer 13.

For these reasons, distortion, improper junction between crystal structures (misfit dislocation), and the like due to difference between the shapes of the crystal planes and difference between lattice constants are unlikely to occur in the crystal structure in a junction part between the first electrode 22 and the second silicon layer 13. The aforementioned electrode material is used in the first electrode 22, since it suppresses occurrence of distortion and misfit dislocation in the crystal structure in the junction part between the piezoelectric layer 21 and the first electrode 22, and has a high temperature resistance, and the like.

### (Second Electrode)

The second electrode 23 is arranged on the Z1-direction side of the piezoelectric layer 21 to apply the voltage to the piezoelectric layer 21. The second electrode 23 is deposited on the Z1-direction side of the piezoelectric layer 21 by using a known method. The second electrode 23 may be non-crystalline dissimilar to the piezoelectric layer 21, or be crystalline similar to the piezoelectric layer 21. The second electrode 23 is a multilayer electrode that includes an electrode layer and a buffer layer. That is, the second electrode 23 may include titanium (Ti), gold (Au), platinum (Pt), iridium dioxide (IrO₂) or the like as the electrode layer. Also, the second electrode 23 may have include ruthenate (SrRuO₃), lanthanum nickelate (LaNiO₃) and the like as the buffer layer. Here, the second electrode 23 may be a single-layer electrode. Also, the electrode material of the second electrode 23 is not limited to the aforementioned electrode materials.

### (Production Method of Ring Gyroscope)

The following description describes a method of producing the ring gyroscope 100.

The substrate 1, which includes the first silicon layer 11, the silicon dioxide layer 12, and the second silicon layer 13, is first prepared. After the substrate 1 is prepared, the first electrode 22 is formed on the surface 13b of the second silicon layer 13 of the substrate 1 by using epitaxial growth. After the first electrode 22 is formed, the piezoelectric layer 21 is formed on the surface 22a of the first electrode 22 by using epitaxial growth. After the piezoelectric layer 21 is formed, the second electrode 23 is formed on the surface 21b of the piezoelectric layer 21 by using a known method. After the second electrode 23 is formed, the substrate **1,** the piezoelectric layer 21, the first electrode 22 and the second electrode 23 are processed into devices. Subsequently, each ring gyroscope 100 is produced, for example, by dividing the substrate 1 into pieces by using a blade, or the like.

### (Advantages of the Embodiment)

In this embodiment, the following advantages are obtained.

In this embodiment, as described above, the piezoelectric layer 21 includes a piezoelectric element material that includes at least a crystal plane with Miller indices (100) and is grown on the side of the second silicon layer 13 opposite to the first silicon layer 11 side. Here, the substrate 1 includes not only the first silicon layer 11 which has a diamond structure and that includes the crystal plane with Miller indices (111) and has isotropic Young's moduli but also the second silicon layer 13 that includes the crystal plane with Miller indices (100). According to this configuration in which the piezoelectric layer 21 is deposited on a side of the second silicon layer 13 opposite to the first silicon layer 11, since a shape of the crystal plane of the piezoelectric layer 21 and a shape of the crystal plane of the second silicon layer 13 are substantially the same as each other, it is possible to prevent occurrence of distortion, improper junction between crystal structures (misfit dislocation), and the like due to shape difference between the crystal planes in a crystal structure of a junction part between the vibration exciter 2 including the piezoelectric layer 21 and the second silicon layer 13 of the substrate 1. Consequently, the piezoelectric layer 21 that includes at least the crystal plane with Miller indices (100) can be deposited on or above the substrate 1 including the first silicon layer 11 that includes the crystal plane with Miller indices (111). Here, other vibrators, which do not have a rotational symmetric shape and are not brought in rotational symmetric vibration, are not required to keep the rotational symmetric shape when the other vibrators vibrate, and as a result the other vibrators are not required to vibrate with loads being uniformly applied to the entire other vibrators. Contrary to this, when the vibrator 10, which has the rotational symmetric shape such as the ring shape and is required to be brought in rotational symmetric vibration, vibrates, the vibrator is required to keep the rotational symmetric shape. For this reason, when the vibrator 10 vibrates in the in-plane direction of the surface 13b of the substrate 1, even if the same load is applied in a rotational symmetric direction to bring the vibrator 10, which has the rotational symmetric shape, to experience in the rotational symmetric shape, in a case in which Young's moduli in directions each of which is the in-plane direction of the substrate 1 are different from each other, deformations in the directions each of which is the in-plane direction of the substrate 1 become different from each other, and as a result the rotational symmetric shape of the vibrator 10 cannot be kept. To address this, in the vibrator 10, the Young's moduli of the material of the vibrator 10 is necessarily isotropic. That is, according to this configuration in which the piezoelectric layer 21 is provided on or above the substrate 1 including the first silicon layer 11 that includes the crystal plane with Miller indices (111), since the first silicon layer 11 which has a diamond structure and that includes the crystal plane with Miller indices (111) has isotropic Young's moduli, the piezoelectric layer 21 can properly vibrate when the piezoelectric layer 21 vibrates on or above the substrate 1. Consequently, since the piezoelectric layer 21 can properly vibrate, the ring gyroscope 100 can accurately detect angular velocity.

In this embodiment, as described above, the vibrator 10 has a rotational symmetric shape with respect to the center Ce of the piezoelectric layer 21 as viewed from the Z1-direction side. Also, the vibrator 10 is configured to vibrate rotational-symmetrically with respect to the center Ce of the piezoelectric layer 21. Here, Young's moduli of the first silicon layer 11, which has a predominant influence on mechanical properties of the vibrator 10, is required to be isotropic in plane directions of the substrate 1 in order for the vibrator 10 having the rotational symmetric shape to rotational-symmetrically vibrate. Accordingly, in the ring gyroscope 100, since the vibrator 10 having the rotational symmetric shape and rotational-symmetrically vibrating is provided on or above the substrate 1 including the first silicon layer 11 which has a diamond structure and that includes the crystal plane having Miller indices (111) and has isotropic Young's moduli, it is possible to realize the ring gyroscope 100 effectively using a property of isotropic Young's moduli of the first silicon layer 11 which has a diamond structure and that includes the crystal plane having Miller indices (111).

Also, in this embodiment, as described above, a thickness Th2 of the second silicon layer 13 is smaller than a thickness Th1 of the first silicon layer 11 in the Z direction. According to this configuration in which the thickness Th2 of the second silicon layer 13 is smaller than the thickness Th1 of the first silicon layer 11, since isotropic deformation of the first silicon layer 11 has a greater effect than anisotropic deformation of the second silicon layer 13 in vibration of the piezoelectric layer 21, the substrate 1 can be isotropically deformed. Consequently, the vibrator 10 can rotational-symmetrically vibrate on the surface of the substrate 1.

Also, in this embodiment, as described above, the piezoelectric layer 21 includes lead zirconate titanate as the piezoelectric element material, which includes at least the crystal plane with Miller indices (100). Accordingly, since a sufficient drive amount can be provided to the piezoelectric layer 21 by the lead zirconate titanate, which has better piezoelectric performance than other materials, it is possible to further prevent deterioration of the piezoelectric layer 21 from accelerating.

Also, in this embodiment, as described above, the piezoelectric layer 21 has the ring shape as viewed from the Z1-direction side (one side). Accordingly, since an area of the ring-shaped piezoelectric layer to be vibrated can be smaller than that of a disc-shaped piezoelectric layer 21 that has the same diameter as the ring-shaped piezoelectric layer 21, power supplied to the vibrator to be vibrated can be relatively small.

Also, in this embodiment, as described above, the vibration exciter 2 further includes the first electrode 22 arranged between the piezoelectric layer 21 and the second silicon layer 13 to apply a voltage to the piezoelectric layer 21, and the second electrode 23 arranged on the Z1-direction side of the piezoelectric layer 21 to apply the voltage to the piezoelectric layer 21. The first electrode 22 is formed of electrode materials each of which includes a crystal plane with Miller indices (100), and is grown on a surface 13b of the second silicon layer 13 on the Z1-direction side. Accordingly, since the piezoelectric layer 21 that includes at least the crystal plane with Miller indices (100) can be provided on the Z1-direction side of the first electrode 22 by forming the first electrode 22 of an electrode material including a crystal plane with Miller indices (100), it is possible to provide the ring gyroscope 100 including the piezoelectric layer 21 capable of surely providing a sufficient drive amount even if the voltage applied through the first electrode 22 and the second electrode 23 is low. Also, since the first electrode 22 including the crystal plane having Miller indices (100) is deposited on the Z1-direction side of the second silicon layer 13 including the crystal plane having Miller indices (100) so that a shape of the crystal plane of the first electrode 22 and a shape of the crystal plane of the second silicon layer 13 are the same as each other, it is possible to prevent occurrence of distortion, improper junction between crystal structures (misfit dislocation), and the like due to shape difference between the crystal planes in a crystal structure of a junction part between the first electrode 22 and the second silicon layer 13.

Also, in this embodiment, as described above, a lattice misfit between the first electrode 22 and the piezoelectric layer 21, and a lattice misfit between the first electrode 22 and the second silicon layer 13 are not greater than 10%. Accordingly, it is possible to further prevent occurrence of distortion, improper junction between crystal structures (misfit dislocation), and the like due to lattice constant difference in a junction part between the piezoelectric layer 21 and the first electrode 22, and a junction part between the second silicon layer 13 and the first electrode 22.

Also, in this embodiment, as described above, a lattice constant of the crystal structure of the first electrode 22 is substantially equal to a lattice constant of the crystal structure of the piezoelectric layer 21 and a lattice constant of the crystal structure of the second silicon layer 13 of the substrate 1. Accordingly, it is possible to furthermore prevent occurrence of distortion, improper junction between crystal structures (misfit dislocation), and the like due to crystal structure lattice constant difference of a crystal structure in the junction part between the piezoelectric layer 21 and the first electrode 22, and a crystal structure in the junction part between the second silicon layer 13 and the first electrode 22. Consequently, the piezoelectric layer 21 that includes the crystal plane with Miller indices (100) as preferred orientation can be deposited on or above the substrate 1 including the crystal plane with Miller indices (111).

Also, in this embodiment, as described above, the substrate 1 includes the silicon dioxide layer 12 that is formed of non-crystalline silicon dioxide and is bonded on a surface 11a of the first silicon layer 11 on the one side and bonded on a surface 13a of the second silicon layer 13 on the Z2-direction side (on a side opposite to the one side) in the thickness direction. Accordingly, as compared with a case in which the first silicon layer 11 and the second silicon layer 13 are directly bonded to each other, the second silicon layer 13 can be easily bonded on the silicon dioxide layer 12 above the first silicon layer 11 by hydrogen-bonding the first silicon layer and the second silicon layer to the silicon dioxide layer 12 and then applying high temperature treatment to them.

Also, in this embodiment, as described above, the substrate 1 is an SOI substrate that includes the first silicon layer 11 as a handle layer, which is supported when the substrate 1 is moved, the silicon dioxide layer 12, and the second silicon layer 13 as a device layer. Accordingly, the ring gyroscope 100 can be easily produced by using the SOI substrates.

Also, in this embodiment, as described above, the piezoelectric layer 21 is formed of a single-crystal piezoelectric element material that includes a crystal plane with Miller indices (100) as the preferred orientation and is grown on the side of the second silicon layer 13 opposite to the first silicon layer 11. Accordingly, the piezoelectric layer 21 of the single-crystal piezoelectric element material having the crystal planes with Miller indices (100) as the preferred orientation can generate a sufficient magnitude (drive amount) of vibration of the piezoelectric layer 21 at a lower voltage as compared with polycrystalline piezoelectric layers. Consequently, since the piezoelectric layer 21 can be vibrated at the lower voltage in the ring gyroscope 100, it is possible to prevent deterioration of the piezoelectric layer 21 from accelerating.

### (Modified Embodiments)

Note that the embodiment disclosed this time must be considered as illustrative in all points and not restrictive. The scope of the present invention is not shown by the above description of the embodiments but by the scope of claims for patent, and all modifications (modified embodiments) within the meaning and scope equivalent to the scope of claims for patent are further included.

While the example in which the substrate 1 is an SOI substrate including the first silicon layer 11, the silicon dioxide layer 12, and the second silicon layer 13 has been shown in the aforementioned embodiment, the present invention is not limited to this. In the present invention, the substrate may include only the first silicon layer and the second silicon layer. In this configuration, the first silicon layer and the second silicon layer have flat surfaces, and are bonded to each other by pressing their flat surfaces together under high pressure in a high vacuum.

Also, while the example in which the piezoelectric layer 21 has a ring shape as viewed from the Z1-direction side has been shown in the aforementioned embodiment, the present invention is not limited to this. In the present invention, the vibrator may have a disc shape, a polygonal plate shape, a donut-shaped polygonal shape, or a polygonal shape as viewed from the Z1-direction side.

Also, while the example in which the piezoelectric layer 21 is formed of lead zirconate titanate as a single-crystal piezoelectric element material that includes the crystal plane with Miller indices (100) as the preferred orientation has been shown in the aforementioned embodiment, the present invention is not limited to this. In the present invention, the vibrator may be formed of a ferroelectric film as a single-crystal piezoelectric element material that includes the crystal plane with Miller indices (100) as the preferred orientation.

Also, while the example in which the piezoelectric layer 21 is formed of a single-crystal piezoelectric element material that includes the crystal plane with Miller indices (100) as the preferred orientation has been shown in the aforementioned embodiment, the present invention is not limited to this. In the present invention, the piezoelectric layer may be formed of a single-crystal piezoelectric element material that includes the crystal plane with Miller indices (001) as the preferred orientation.

Also, while the example in which a lattice constant of the crystal structure of the piezoelectric layer 21 is substantially equal to a lattice constant of the crystal structure of the first electrode 22 has been shown in the aforementioned embodiment, the present invention is not limited to this. In the present invention, the lattice misfit between the first electrode and the piezoelectric layer may be not greater than 10%. That is, although illustrated merely as one example, a total lattice constant of four crystal structures of the piezoelectric layer may be matched with a total lattice constant of three crystal structures of the first electrode, for example, instead of matching the lattice constant of one crystal structure of the piezoelectric layer with the lattice constant of one crystal structure of the first electrode.

Also, while the example in which the lattice constant of the crystal structure of the first electrode 22 is substantially equal to the lattice constant of the crystal structure of the second silicon layer 13 has been shown in the aforementioned embodiment, the present invention is not limited to this. In the present invention, the lattice misfit between the first electrode and the second silicon layer may be not greater than 10%. That is, although illustrated merely as one example, a total lattice constant of four crystal structures of the second silicon layer may be matched with a total lattice constant of three crystal structures of the first electrode, for example, instead of matching the lattice constant of one crystal structure of the second silicon layer with the lattice constant of one crystal structure of the first electrode.

### Description of Reference Numerals

1; substrate
2; vibration exciter
10; vibrator
11; first silicon layer
11a; surface
12; silicon dioxide layer
13; second silicon layer
13a; surface
13b; surface
21; piezoelectric layer
22; first electrode
23; second electrode
100; ring gyroscope (vibration-type angular velocity sensor)
Ce; center
Th1; thickness
Th2; thickness

## Claims

1. A vibration-type angular velocity sensor comprising:
a vibrator including a substrate including a first silicon layer including a crystal plane with Miller indices (111) and a second silicon layer arranged on one side in a thickness direction of the first silicon layer and including a crystal plane with Miller indices (100), and a vibration exciter including a piezoelectric layer arranged on a side of the second silicon layer of the substrate opposite to the first silicon layer side, wherein
the piezoelectric layer includes a piezoelectric element material that includes at least a crystal plane with Miller indices (100) or Miller indices (001) and is grown on the side of the second silicon layer opposite to the first silicon layer side.

2. The vibration-type angular velocity sensor according to claim 1, wherein the vibrator has a rotational symmetric shape with respect to a center of the vibrator as viewed from the one side in the thickness direction, and vibrates rotational-symmetrically with respect to the center of the vibrator.

3. The vibration-type angular velocity sensor according to claim 1, wherein a thickness of the second silicon layer is smaller than a thickness of the first silicon layer in the thickness direction.

4. The vibration-type angular velocity sensor according to claim 1, wherein the piezoelectric layer includes lead zirconate titanate as the piezoelectric element material, which includes at least the crystal plane with Miller indices (100) or Miller indices (001).

5. The vibration-type angular velocity sensor according to claim 2, wherein the vibrator has a ring shape as viewed from the one side.

6. The vibration-type angular velocity sensor according to claim 1, wherein
the vibration exciter further includes
a first electrode arranged between the piezoelectric layer and the second silicon layer to apply a voltage to the piezoelectric layer, and
a second electrode arranged on the one side of the piezoelectric layer to apply the voltage to the piezoelectric layer; and
the first electrode is formed of an electrode material that includes a crystal plane with Miller indices (100), and is grown on a surface of the second silicon layer on the one side.

7. The vibration-type angular velocity sensor according to claim 6, wherein a lattice misfit between the first electrode and the piezoelectric layer, and a lattice misfit between the first electrode and the second silicon layer are not greater than 10%.

8. The vibration-type angular velocity sensor according to claim 7, wherein a lattice constant of a crystal structure of the first electrode is substantially equal to a lattice constant of a crystal structure of the piezoelectric layer and a lattice constant of a crystal structure of the second silicon layer of the substrate.

9. The vibration-type angular velocity sensor according to claim 1, wherein the substrate further includes a silicon dioxide layer that is formed of non-crystalline silicon dioxide and is bonded on a surface of the first silicon layer on the one side and bonded on a surface of the second silicon layer on a side opposite to the one side in the thickness direction.

10. The vibration-type angular velocity sensor according to claim 9, wherein the substrate is an SOI (Silicon on Insulator) substrate that includes the first silicon layer as a handle layer, which is supported when the substrate is moved, the silicon dioxide layer, and the second silicon layer as a device layer.
